**Europäisches Patentamt**

**European Patent Office**

**Office européen des brevets**

(11) Numéro de publication: **0 406 082 A1**

## (12) DEMANDE DE BREVET EUROPEEN

(21) Numéro de dépôt: 90401791.0

(22) Date de dépôt: 25.06.90

(51) Int. Cl.5: **G01R 33/56**

(30) Priorité: 29.06.89 FR 8908712

(43) Date de publication de la demande:
**02.01.91 Bulletin 91/01**

(84) Etats contractants désignés:
**AT BE CH DE DK ES FR GB GR IT LI LU NL SE**

(71) Demandeur: **MAGNETECH**
**Parc Club, 28, Rue Jean Rostand**
**F-91893 Orsay(FR)**

(72) Inventeur: **Mao, Lill**
**5, Square des Champs Frétants**
**F-91120 Palaiseau(FR)**
Inventeur: **Saint-Jalmes, Hervé**
**8, rue Cygne**
**F-75001 Paris(FR)**
Inventeur: **Darrasse, Luc**
**14, rue d'Aligre**
**F-75012 Paris(FR)**

(74) Mandataire: **Casalonga, Axel et al**
**BUREAU D.A. CASALONGA - JOSSE**
**Morassistrasse 8**
**D-8000 München 5(DE)**

(54) **Procédé d'imagerie tridimensionnelle par résonance magnétique nucléaire.**

(57) Le procédé d'imagerie tridimensionnelle par résonance magnétique nucléaire d'un corps disposé dans un champ magnétique statique est constitué des étapes séquentielles suivantes :
- appliquer un champ magnétique d'excitation ($B_1$) sous forme d'une première impulsion (1) basculant l'aimantation initiale du corps d'un angle compris entre 90° et 180° ;
- appliquer une première impulsion (2, 3, 4) suivie d'une seconde impulsion (5, 6, 7) de gradients de champ magnétique suivant chacun des trois axes d'un repère tridimensionnel,
- appliquer une seconde impulsion (8) du champ d'excitation ($B_1$) permettant de basculer l'aimantation d'un angle de 180° ;
- appliquer une troisième impulsion (9, 10, 11) de gradients de champ suivant chacun des axes du repère tridimensionnel;
- appliquer une quatrième impulsion (12) de l'un des gradients en l'absence de deux autres gradients et pendant laquelle on mesure un signal (13);
- appliquer une impulsion (14, 15, 16) de gradients suivant chaque axe du repère tridimensionnel;
- répéter la séquence ainsi définie, de sorte qu'à chaque répétition, on incrémente l'amplitude de l'une des premières impulsions de gradient (3, 4), les amplitudes des autres impulsions de gradients, à l'exception de l'impulsion 12, variant de façon aléatoire et indépendante d'une répétition à l'autre.

**FIG.2**

## PROCEDE D'IMAGERIE TRIDIMENSIONNELLE PAR RESONANCE MAGNETIQUE NUCLEAIRE.

La présente invention concerne un procédé d'imagerie par résonance magnétique nucléaire.

Plus particulièrement, la présente invention concerne un procédé d'imagerie médicale tridimensionnelle par résonance magnétique nucléaire pour des examens cliniques.

L'imagerie par résonance magnétique nucléaire est une technique qui offre intrinsèquement un contraste élevé entre les différents tissus biologiques à la différence d'autres techniques d'examen clinique, telles que l'échographie et la radiographie aux rayons X. Elle peut donc constituer un outil remarquable en vue d'un diagnostic médical.

On sait que certains types de noyaux atomiques, tels que $^1H$, $^{13}C$, $^{23}Na$, $^{31}P$ et $^{19}F$, possèdent une aimantation nucléaire en présence d'un champ magnétique. Il en résulte qu'un corps contenant au moins un de ces types de noyaux atomiques présente une aimantation macroscopique lorsqu'il est placé dans un champ magnétique.

L'aimantation d'un corps se trouvant dans un champ magnétique statique représente un état d'équilibre thermique du corps dans ce champ magnétique. Après avoir été soumis à une onde électromagnétique dite d'excitation, certains noyaux atomiques, tels que les protons, émettent à leur tour une onde électromagnétique à une fréquence précise. Ce phénomène est connu sous le nom de "résonance magnétique nucléaire" et représenté par une relation dite de Larmor :

$$\vec{\omega}_0 = - \gamma \vec{B}_0$$

où $\gamma$ est le rapport gyromagnétique caractéristique de chaque type de noyaux atomiques; $\vec{w}_0$ est la vitesse angulaire de l'aimantation correspondant à la fréquence de Larmor; $\vec{B}_0$ est le champ magnétique statique d'intensité $B_0$.

Ainsi, pour des types différents de noyaux atomiques placés dans le champ magnétique statique $B_0$, les fréquences de résonance ou fréquences de Larmor correspondantes sont différentes l'une de l'autre. Il est alors possible d'étudier un type de noyau atomique de manière indépendante même s'il est entouré par d'autres types de noyaux atomiques présents dans le corps.

Le principe de l'imagerie par résonance magnétique nucléaire peut être résumé très schématiquement de la façon suivante.

On applique un champ magnétique tournant ou variable dans le domaine des radiofréquences, ou une onde électromagnétique, sous forme d'impulsions, pour exciter les noyaux atomiques hors de leur équilibre thermique dans le champ magnétique statique, ce qui se traduit par une déviation de l'aimantation par rapport à la position d'équilibre initiale. Après la suppression du champ magnétique d'excitation, l'aimantation revient à son équilibre initial et transmet un signal de résonance dont l'amplitude dépend de la densité des noyaux atomiques considérés et des constantes de temps de relaxation caractérisant le retour à l'équilibre de l'aimantation. On mesure le signal de résonance à l'aide, par exemple d'un courant induit dans une bobine placée près du corps. Le signal mesuré peut être traité par des techniques informatiques dans le but de reconstituer une image numérique du corps.

La fréquence de résonance est proportionnelle à l'intensité locale du champ magnétique statique. On superpose des gradients de champ magnétique au champ magnétique statique de façon à obtenir une relation linéaire entre la position spatiale d'un volume élémentaire du corps et la fréquence du signal émis par ce volume élémentaire. De cette manière, on peut analyser le spectre de fréquences du signal de résonance et obtenir des informations sur les volumes élémentaires correspondants. Parmi les méthodes d'analyse du signal, on peut citer la transformée de Fourier mise en valeur en particulier par A. Kumar et al. dans "Journal of Magnetic Resonance" (n° 18, page 69, 1975) et par H.B. Song et al. dans "IEEE, NS-29" (page 493, 1982).

Les informations obtenues, après un certain nombre de répétitions de cycles d'excitation et de mesure, permettent d'établir une image numérique visualisant l'intérieur du corps observé, par exemple en suivant un plan de coupe choisi.

L'imagerie par résonance magnétique nucléaire est une technique non destructive pour les tissus biologiques. Son application dans le domaine clinique, connue sous le nom d'imagerie médicale par résonance magnétique nucléaire, est particulièrement mise en valeur, en raison de l'abondance de l'eau ($H_2O$) dans le corps humain ou animal. Les noyaux atomiques les plus souvent considérés sont dans ce cas, les protons ($^1H$).

Actuellement, la technique standard de l'imagerie médicale par résonance magnétique nucléaire pour des examens cliniques est basée sur une méthode dite écho de spin. Cette méthode permet d'éliminer efficacement les problèmes liés aux défauts de champ magnétique statique et de fournir un contraste élevé des tissus biologiques dans les images. Elle permet, en conséquence, de réaliser des images cliniques de grande qualité, en particulier celles du système nerveux central d'un patient. A partir de ces images, le médecin est ensuite amené à établir son diagnostic.

Cependant, la technique standard est pénalisée par sa lenteur. En effet, le temps de pose pendant lequel l'examen est pratiqué est de l'ordre de quelques minutes pour l'obtention d'une image bidimensionnelle correspondant à une vue en coupe de la partie examinée du patient. L'acquisition d'une image tridimensionnelle par cette technique nécessite un temps de pose dépassant quelques heures.

La lenteur d'acquisition a comme conséquences directes un coût élevé de l'examen dû au temps d'occupation de l'appareil d'examen et l'inconfort du patient pendant la durée de l'examen.

En outre, l'ensemble des mouvements du patient pendant le temps de pose, soit volontaires chez les enfants, soit respiratoires, cardiaques ou péristaltiques, génèrent des artefacts difficiles à éliminer et réduit sévèrement l'étendue d'application de cette technique.

Afin de réduire le temps de pose, un certain nombre de techniques rapides ont été élaborées récemment. La plupart de ces techniques rapides demeurent cependant inexploitables à l'heure actuelle.

La technique rapide la plus susceptible d'être utilisée en examens cliniques est basée sur une méthode dite rapide à petit angle d'excitation (connue sous la dénomination "FLASH" ou "Fast Low Angle Shot"). Cette méthode est capable de réduire, grâce à des répétitions rapides d'excitation de l'aimantation, le temps de pose d'un facteur 100 par rapport à la technique standard. De plus, elle n'implique pas de contraintes technologiques supplémentaires pour sa mise en oeuvre.

Néanmoins, cette technique est sensible aux défauts de champ magnétique. Elle introduit généralement des artefacts et fournit un contraste médiocre pour l'image. L'utilisation de cette technique rapide pour l'obtention d'images en vue d'un examen clinique demeure, jusqu'à présent, très limitée.

La présente invention a pour objet un procédé d'imagerie par résonance magnétique nucléaire relativement rapide, insensible aux défauts de champ magnétique, et permettant d'obtenir des images sans artefacts et ayant un contraste de bonne qualité.

Un autre objet de la présente invention est la mise en oeuvre d'un procédé d'imagerie médicale tridimensionnelle par résonance magnétique nucléaire simple à adapter aux appareils d'imagerie existants dans des cliniques et hôpitaux. On comprendra bien entendu que l'invention ne constitue pas une méthode de diagnostic en tant que telle mais permet simplement de réaliser des images qui peuvent ensuite servir au médecin à l'établissement du diagnostic proprement dit.

Le procédé d'imagerie par résonance magnétique nucléaire, pour l'examen d'un corps disposé dans un champ magnétique statique, selon l'invention, est constitué par les étapes suivantes se succédant séquentiellement :

- appliquer un champ magnétique d'excitation perpendiculairement au champ statique et tournant autour du champ statique à une vitesse angulaire correspondant sensiblement à la fréquence de résonance d'un type de noyaux atomiques constituant le corps sous le champ statique, le champ d'excitation étant appliqué sous forme d'une première impulsion dont l'amplitude et la durée sont choisies de façon à basculer l'aimantation induite du corps dans le champ statique d'un angle compris entre 90° et 180° par rapport à sa position d'équilibre d'origine dans le champ statique;

- appliquer selon chacun des axes d'un repère tridimensionnel, une impulsion de gradient de champ magnétique, l'un desdits gradients étant un gradient de lecture avec une amplitude et une durée déterminées, les deux autres gradients de champ magnétique étant des gradients de codage de phase;

- appliquer une seconde impulsion de chacun des gradients de champ;

- appliquer une seconde impulsion du champ magnétique d'excitation de façon à basculer encore une fois l'aimantation d'un angle de 180° ;

- appliquer une troisième impulsion de chacun des gradients de champ;

- appliquer une quatrième impulsion du gradient de lecture en l'absence des deux autres gradients de champ magnétique;

- mesurer le signal transmis par l'aimantation pendant la quatrième impulsion du gradient de lecture, ledit signal mesuré étant traité par des moyens appropriés pour permettre la réalisation d'une image numérique;

- appliquer une cinquième impulsion du gradient de lecture et simultanément une quatrième impulsion de chacun des deux autres gradients de champ;

- répéter la séquence précédemment définie de telle sorte qu'à chaque répétition, on change l'aire formée par la multiplication de la durée et de l'amplitude de la première impulsion de l'un des gradients de codage de phase par exemple par saut de niveaux ou par incrément de l'amplitude, les amplitudes des seconde, troisième et cinquième impulsions de gradient de lecture et des secondes, troisièmes et quatrièmes impulsions de gradients de codage de phase variant de façon aléatoire et indépendante d'une répétition à l'autre.

Le repère tridimensionnel peut présenter une orientation quelconque en fonction des exigences de l'examen du corps.

De préférence, le temps séparant la mi-durée de la première impulsion d'excitation et la mi-durée de la seconde impulsion d'excitation est sensiblement identique au temps séparant la mi-durée de la seconde impulsion d'excitation et l'instant où l'amplitude du signal mesuré est maximale.

D'une façon particulièrement avantageuse, l'aire formée par la multiplication de la durée et de l'amplitude de la première impulsion du gradient de lecture est identique à l'aire correspondante d'une partie de la quatrième impulsion du gradient de lecture comprise entre le début de l'impulsion et l'instant où l'amplitude du signal mesuré est maximale. A chaque répétition de la séquence, l'aire de chacune des secondes impulsions de gradients de champ peut de préférence être identique à l'aire de la troisième impulsion de gradients de champ correspondant.

Avantageusement, au moins un des groupes d'impulsions des gradients de champ d'amplitude aléatoire vérifie la relation suivante :

$$\gamma (G_x\, t_x\, Dx + G_y\, t_y\, Dy + G_z\, t_z\, Dz) \geq 2\pi \qquad (I)$$

où $\gamma$ est le rapport gyromagnétique caractéristique du type de noyaux atomiques considéré; $G_x$ est l'amplitude d'impulsion de gradient de lecture; $G_y$, $G_z$ sont les amplitudes d'impulsions respectives de gradient de codage de phase; $t_x$, $t_y$, $t_z$ sont les durées respectives des impulsions de gradient; $Dx$, $Dy$, $Dz$ sont les côtés d'un volume élémentaire considéré du corps.

Le volume élémentaire, appelé voxel est déterminé par le pouvoir de résolution du procédé. L'image d'un voxel est appelée un pixel. D'une manière générale, une image bidimentionnelle est constituée de 256 x 256 pixels, et une image tridimensionnelle 32 x 256 x 256 ou 64 x 128 x 256 pixels.

L'angle de basculement de l'aimantation par la première impulsion du champ d'excitation est de préférence constant et inchangé d'une répétition à l'autre de la séquence.

Il est possible, lorsque l'on veut examiner partiellement le corps, de n'exciter qu'un volume bien déterminé du corps. On applique alors, pour chaque répétition de la séquence et avant les premières impulsions de gradients de champ magnétique, un gradient de sélection suivant au moins un des axes du repère tridimensionnel sous forme d'une première partie d'impulsion pendant laquelle est appliquée la première impulsion d'excitation, suivie d'une seconde partie d'impulsion dont l'amplitude est de signe contraire à celle de la première partie d'impulsion. L'aire de la première partie d'impulsion après la mi-durée de la première impulsion du champ d'excitation est de préférence sensiblement égale à l'aire de la seconde partie d'impulsion du gradient de sélection.

L'invention sera mieux comprise à l'étude de la description détaillée d'un mode de réalisation pris à titre d'exemple nullement limitatif et illustré par les dessins annexés, sur lesquels :

les figures 1a et 1b montrent le principe d'excitation de l'aimantation; et

la figure 2 montre une séquence du procédé de l'invention.

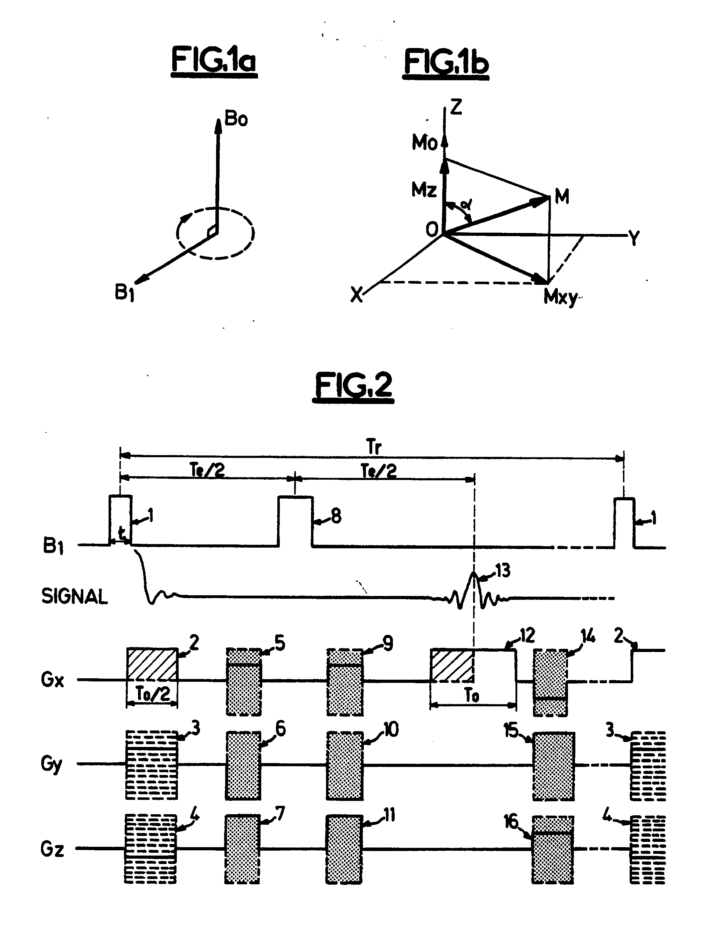

Afin de faciliter la compréhension de l'invention, la direction parallèle au champ magnétique statique, qui correspond à la direction axiale des moyens du champ magnétique statique, sera désignée comme la direction longitudinale et représentée verticalement sur les figures 1a et 1b. Un plan perpendiculaire au champ statique sera désigné comme plan transversal.

Comme illustré sur les figures 1a et 1b, lorsqu'un corps contenant par exemple une grande quantité de protons est introduit dans le champ statique $B_0$ longitudinal, il possède une aimantation macroscopique $M_0$ parallèle au champ statique $B_0$. L'intensité de l'aimantation $M_0$ est proportionnelle à l'intensité du champ statique $B_0$ et au nombre de protons contenus dans le corps. L'aimantation $M_0$ représente l'équilibre thermique des protons du corps dans le champ statique.

On applique un champ magnétique $B_1$, nommé champ d'excitation, perpendiculairement au champ statique $B_0$. Le champ d'excitation est rotatif autour du champ statique dans le plan transversal, comme représenté par le trajet en pointillés et fléché sur la figure 1a. La vitesse de rotation du champ d'excitation correspond au domaine des radiofréquences, et de préférence à une fréquence voisine ou égale à la fréquence de résonance des protons dans le champ statique $B_0$.

Le champ d'excitation $B_1$ est appliqué sous forme d'une impulsion pendant laquelle l'aimantation M du corps s'écarte de sa position d'équilibre initial $M_0$ et effectue un mouvement de précession forcée autour de la direction longitudinale. L'angle $\alpha$ formé entre l'aimantation instantanée M et l'aimantation d'origine $M_0$, à la fin de l'impulsion d'excitation $B_1$, est appelé l'angle de basculement et est proportionnel à l'amplitude de l'impulsion d'excitation $B_1$ et à la durée de l'impulsion t.

Lorsque le champ d'excitation $B_1$ est supprimé, l'aimantation M, sous l'effet du champ statique $B_0$, tend à retrouver son équilibre initial $M_0$. Le mouvement de retour à l'équilibre de l'aimantation M est un mouvement de précession libre amortie, appelé également mouvement de relaxation.

A tout moment, l'aimantation M peut être décomposée en une composante transversale $M_{xy}$ et une composante longitudinale $M_z$. Le mouvement de précession libre amortie peut alors être décomposé en un mouvement de relaxation longitudinale avec une constante de temps $T_1$, et un mouvement de relaxation transversal avec une constante de temps $T_2$.

L'imagerie du corps par résonance magnétique nucléaire consiste essentiellement à mesurer son aimantation d'équilibre $M_0$ dans le champ statique $B_0$, et les constantes de temps de relaxation longitudinale $T_1$ et transversale $T_2$. Le contraste des images obtenu est fonction de la densité des protons et des constantes de temps de relaxation $T_1$ et $T_2$.

La figure 2 montre une séquence particulière de l'invention, permettant d'obtenir une image tridimensionnelle avec un contraste de très bonne qualité et un temps de pose relativement court. Les événement représentés sur la figure 2 ont lieu respectivement et séquentiellement de gauche à droite de la figure sur laquelle : "$B_1$" désigne le champ magnétique d'excitation; "SIGNAL" représente le signal transmis pouvant être mesuré pendant la séquence; "$G_x$" désigne un gradient de champ magnétique dit de lecture; "$G_y$" et "$G_z$" représentent chacun un gradient de champ magnétique dit de codage de phase.

D'après la relation de Larmor, la fréquence de Larmor ou la fréquence de résonance est proportionnelle à l'intensité du champ magnétique. L'imagerie par résonance magnétique nucléaire nécessite une localisation spatiale du signal dans le corps observé. La localisation spatiale du signal se traduit par une discrimination spatiale par la fréquence de Larmor qui est fonction de l'intensité locale du champ magnétique. Cette discrimination spatiale peut être obtenue dans une direction quelconque à l'aide d'un gradient de champ magnétique établi dans cette direction. Ainsi, une discrimination tridimensionnelle nécessite trois gradients de champ magnétique suivant trois directions non coplanaires selon les axes d'un repère tridimensionnel.

Pour une excitation volumique, le signal transmis est un signal global dans tout le volume. Grâce à la technique de la transformée de Fourier, on peut effectuer un codage en phase et en fréquence permettant de reconstituer la distribution spatiale de l'aimantation et de représenter cette distribution spatiale sur une image numérique.

L'obtention d'une image nécessite un grand nombre de mesures. La séquence montrée sur la figure 2 est valable pour une mesure. Cette séquence doit être répétée autant de fois qu'il est nécessaire pour obtenir une image bidimensionnelle ou tridimensionnelle. Le temps séparant deux répétitions consécutives est appelé temps de répétition $T_r$.

Comme on peut le voir sur la figure 2, la séquence pour une répétition, selon l'invention, commence par une première impulsion 1 du champ d'excitation d'amplitude $B_1$ et de durée t. Cette première impulsion d'excitation a pour but de faire basculer l'aimantation M d'un angle de basculement $\alpha$ supérieur ou égal à 90˚ et inférieur à 180˚.

Après la première impulsion d'excitation 1, on applique simultanément trois gradients de champ magnétique sous forme des premières impulsions 2, 3, 4 suivant les trois axes d'un repère tridimensionnel. Ce repère tridimensionnel peut être orthogonal et orienté suivant les exigences de l'examen.

Les premières impulsions 2, 3, 4 des gradients de champ magnétique $G_x$, $G_y$ et $G_z$ permettent une discrimination spatiale tridimensionnelle du corps par l'intensité du champ magnétique.

La première impulsion 2 du gradient du champ de lecture $G_x$ présente une amplitude et une durée bien déterminées qui sont constantes d'une répétition à l'autre de la séquence. Les premières impulsions 3, 4 des gradients de codage de phase $G_y$ et $G_z$ présentent avantageusement chacune une durée constante et une amplitude pouvant varier par incrément d'une répétition à l'autre. Comme illustré sur la figure 2, les premières impulsions 3, 4 de $G_y$ et $G_z$ en trait plein montrent que, pour la répétition représentée de la séquence, l'amplitude de la première impulsion 3 de $G_y$ est positive tandis que l'amplitude de la première impulsion 4 de $G_z$ est négative. Les traits horizontaux en pointillés montrent de façon schématique les différents niveaux d'amplitude pouvant être atteints par $G_y$ et $G_z$ pour d'autres répétitions de la séquence.

Après les premières impulsions des gradients de champ, on applique une seconde impulsion 5, 6 et 7 pour chacun desdits gradients $G_x$, $G_y$ et $G_z$. Ces secondes impulsions de gradient sont représentées par des rectangles sombres pour signifier que d'une répétition à l'autre, l'amplitude de chacune de ces impulsions 5, 6 et 7 peut varier d'une façon aléatoire et indépendante l'une de l'autre, tandis que la durée de chacune de ces impulsions est constante d'une répétition à l'autre. Dans l'exemple illustré, les traits pleins montrent que pour la répétition choisie, l'amplitude de la seconde impulsion 5 du gradient de lecture $G_x$ est positive, que l'amplitude de la seconde impulsion 6 de l'un des gradients de codage de phase $G_y$ est maximum dans les valeurs négatives, et que l'amplitude de la seconde impulsion 7 de l'autre gradient de codage de phase $G_z$ atteint une valeur maximum positive.

On applique ensuite une seconde impulsion 8 du champ d'excitation $B_1$ dont l'amplitude et la durée sont telles que l'aimantation M est basculée de nouveau d'un angle de 180˚ à la fin de cette impulsion d'excitation 8. Dans cet exemple, l'amplitude de la seconde impulsion d'excitation 8 est identique à celle de la première impulsion d'excitation 1.

On applique alors une troisième impulsion 9, 10 et 11 pour chacun des gradients de champ $G_x$, $G_y$ et $G_z$. L'amplitude et la durée de chacune des troisièmes impulsions 9, 10 et 11 sont identiques, dans cet exemple, à celles des secondes impulsions correspondantes 5, 6 et 7. Chaque paire de seconde et troisième impulsions de gradient de champ 5 et 9; 6 et 10; 7 et 11 peut être symétrique par rapport à la seconde impulsion d'excitation 8 sur l'échelle du temps.

Après les troisièmes impulsions des gradients de champ, on applique une quatrième impulsion 12 du gradient de lecture $G_x$ pendant que les gradients de codage de phase $G_y$ et $G_z$ sont absents. On effectue une mesure du signal 13 pendant la quatrième impulsion 12 du gradient de lecture. Le signal 13 mesuré pendant le temps d'observation est traité par des moyens informatiques appropriés, par exemple par la technique de la transformée de Fourier, pour être ensuite stocké et utilisé pour la reconstitution des images d'une manière bien connue de l'homme du métier.

La durée de la quatrième impulsion 12 du gradient de lecture $G_x$, désignée comme le temps d'observation $T_0$, est égale, dans cet exemple, au double de la durée de la première impulsion 2 du gradient de lecture, l'amplitude de la quatrième impulsion 12 étant identique à l'amplitude de la première impulsion 2 du gradient de lecture.

Après la mesure du signal 13 et avant la répétition suivante de la séquence, on applique simultanément une cinquième impulsion 14 du gradient de lecture $G_x$, et une quatrième impulsion 15, 16 de chacun des gradients de codage de phase $G_y$, $G_z$. Comme pour les secondes et troisièmes impulsions des gradients de champ, ces impulsions 14, 15 et 16, représentées par des zones sombres, ont chacune une durée constante et une amplitude aléatoire et indépendante l'une de l'autre d'une répétition à l'autre. Les durées respectives des impulsions 14, 15 et 16 peuvent être identiques ou différentes l'une de l'autre.

Il est important de noter que le temps séparant les mi-durées respectives des deux impulsions d'excitation 1 et 8 doit être sensiblement égal au temps séparant la mi-durée de la seconde impulsion d'excitation 8 et l'instant où le signal 13 présente une amplitude maximum. Le temps entre la mi-durée de la première impulsion d'excitation 1 et ledit instant est appelé temps d'écho $T_e$.

La raison principale de ce choix est la suivante. Le champ magnétique statique $B_0$ présente en pratique des défauts d'homogénéité. L'environnement chimique des protons présente également un effet d'écran au champ statique 80 créant ainsi un phénomène appelé décalage chimique des spectres du signal. Les défauts du champ statique et le décalage chimique des protons créent un déphasage notamment dans les composantes transversales de l'aimantation. Etant donné que pour des raisons diverses, on ne peut valablement mesurer que les variations de la composante transversale $M_{xy}$ de l'aimantation, ce déphasage peut introduire des erreurs de mesures et créer notamment une distorsion dans l'intensité de l'image.

Afin de supprimer ces effets indésirables, on applique deux impulsions d'excitation 1 et 8 séparées par un intervalle de temps voisin de la moitié du temps d'écho $T_e$. La première impulsion d'excitation 1 bascule l'aimantation d'un angle $\alpha$. Les composantes transversales de l'aimantation ainsi obtenues se déphasent progressivement dans le temps. La deuxième impulsion d'excitation 8 bascule chaque composante transversale de l'aimantation d'un angle égal à $180°$. Ce qui a pour effet une inversion du déphasage de ces composantes transversales.

A l'instant $T_e$, le déphasage dû aux effets indésirables est égal à zéro, puisque les composantes transversales de l'aimantation sont déphasées de la même quantité après la seconde impulsion d'excitation 8 qu'avant la seconde impulsion d'excitation 8. L'amplitude du signal à l'instant $T_e$ est de ce fait maximale. Ce signal est appelé "écho de spin".

L'obtention d'un écho maximal et significatif nécessite que le gradient de lecture présent pendant la mesure ait un effet global négligeable à l'instant $T_e$. C'est la raison pour laquelle l'aire hachurée de la partie de l'impulsion 12 comprise entre le début de l'impulsion et l'instant de l'écho $T_e$ doit être sensiblement égale à l'aire hachurée de la première impulsion 2 du gradient de lecture.

Le temps d'observation $T_0$ est de préférence centré par rapport à l'écho 13 et petit devant la constante de temps de relaxation transversale $T_2$, afin qu'on puisse négliger la variation de l'amplitude de l'aimantation transversale pendant la mesure. Le gradient de lecture $G_x$ présent, par la quatrième impulsion 12, pendant l'acquisition du signal 13 permet de faire correspondre la fréquence du signal à la position spatiale suivant un axe du repère tridimensionnel. Les gradients de codage de phase $G_y$ et $G_z$ permettent de varier la phase initiale du signal en fonction de la position spatiale suivant les deux autres axes du repère tridimensionnel.

Dans la pratique, il est impossible d'obtenir un champ d'excitation $B_1$ totalement homogène. En effet, l'inhomogénéité spatiale de ce champ d'excitation peut atteindre de l'ordre 10%. Il en résulte que la seconde impulsion d'excitation 8 ne permet pas de basculer toutes les composantes de l'aimantation d'un angle égal à $180°$ pour tout le volume observé. Cette impulsion d'excitation peut donc générer des composantes longitudinales à partir des composantes transversales de l'aimantation créées par la première impulsion d'excitation 1, et également créer des composantes transversales à partir des composantes longitudinales de l'aimantation générées par la première impulsion d'excitation 1.

Or, lesdites composantes transversales de l'aimantation, créées par la première impulsion d'excitation 1, sont codées en fréquence et en phase en fonction de leur position spatiale par les premières impulsions 2, 3, 4 de gradients de champ avant la seconde impulsion d'excitation 8. Les nouvelles composantes longitudinales de l'aimantation créées par la seconde impulsion d'excitation 8 portent donc les mêmes informations spatiales qu'avant ladite seconde impulsion d'excitation. Ces composantes longitudinales peuvent compromettre le codage pour les répétitions ultérieures et introduire de ce fait des artefacts dans l'image.

En outre, étant donné que les premières impulsions 2, 3, 4 de gradients de champ, appliquées avant la seconde impulsion d'excitation 8, n'ont pas d'effet sur les composantes longitudinales de l'aimantation, les nouvelles composantes transversales générées par la seconde impulsion d'excitation 8 ne sont donc pas correctement codées. Ces nouvelles composantes transversales sont mesurées en même temps que les composantes transversales créées par la première impulsion d'excitation 1 et codées par les premières impulsions 2, 3, 4 de gradients de champ, et introduisent également en conséquence des artefacts.

Afin de supprimer les composantes longitudinales et transversales indésirables dues à l'inhomogénéité du champ d'excitation $B_1$, on applique les impulsions 5, 6, 7, 9, 10, 11 de gradients de champ avant et après la seconde impulsion d'excitation 8. Chaque paire d'impulsions de gradient 5 et 9, 6 et 10, 7 et 11 produit des déphasages de l'aimantation identiques avant et après la seconde impulsion d'excitation 8. Les déphasages correspondants n'ont pas d'effet global sur les composantes transversales et longitudinales de l'aimantation créées par la première impulsion d'excitation 1.

Ces impulsions de gradients de champ permettent d'éliminer efficacement les nouvelles composantes longitudinales ou transversales de l'aimantation créées par la seconde impulsion d'excitation 8. En effet, ces nouvelles composantes sont déphasées soit par les impulsions de gradients 5, 6, 7 avant la seconde impulsion d'excitation 8, soit par les impulsions de gradients 9, 10, 11 après ladite seconde impulsion d'excitation. Les amplitudes desdites impulsions de gradient sont aléatoires d'une répétition à l'autre, ce qui implique un déphasage aléatoire des composantes transversales de l'aimantation d'une répétition à l'autre. Lorsqu'on effectue un grand nombre de répétitions de mesure, les effets provoqués par ces impulsions de gradients s'éliminant en moyenne.

Pour éliminer complètement la possibilité de formation d'artefacts, il est nécessaire, avant chaque répétition, de supprimer l'influence des composantes transversales résiduelles de l'aimantation de la répétition précédente, de façon à ne pas perturber les répétitions suivantes. C'est le but des impulsions de gradient 14, 15 et 16 après l'acquisition du signal 13 et avant la répétition suivante. Ces impulsions de gradient, d'amplitude aléatoire d'une répétition à l'autre, créent des déphasages aléatoires des composantes transversales de l'aimantation qui s'éliminent en moyenne pour un certain nombre de répétitions.

Pour que les impulsions de gradient d'amplitude aléatoire soient efficaces, il est préférable que chacun des trois groupes d'impulsions 5, 6, 7; 9, 10, 11; et 14, 15, 16 vérifie la relation (I) pour qu'il puisse créer un déphasage supérieur ou égal à $2\pi$ des composantes transversales de l'aimantation.

Le procédé de l'invention permet ainsi de supprimer d'une part l'influence des défauts de champs magnétiques et du décalage chimique du type de noyaux atomiques considéré, et d'autre part l'influence des composantes de l'aimantation créées involontairement par des impulsions d'excitation dans l'imagerie par résonance magnétique nucléaire. Les images obtenues selon le procédé de l'invention présentent donc un contraste de bonne qualité sans artefact, et correspondent bien à la réalité des tissus observés.

Le signal mesuré 13 dépend d'une part des trois paramètres de la résonance magnétique nucléaire, à savoir l'intensité de l'aimantation d'équilibre $M_0$ et les temps de relaxation longitudinale $T_1$ et transversale $T_2$, et d'autre part des paramètres de la séquence de mesure, à savoir le temps d'écho $T_e$ et le temps de répétition $T_r$. Pour un champ statique $B_0$ donné, on peut faire varier le contraste des images d'un corps en modifiant les paramètres de la séquence $T_e$ et $T_r$.

En effet, le signal mesuré pendant une répétition dépend directement des composantes transversales de l'aimantation. Lorsqu'on modifie le temps d'écho $T_e$, on modifie l'instant où se produit l'écho 13 dans la relaxation transversale de l'aimantation. On modifie de ce fait le contraste en $T_2$ de l'image. On peut donc accentuer ou diminuer le contraste de l'image en $T_2$ en augmentant ou en réduisant le temps d'écho $T_e$.

Lorsque le temps de répétition $T_r$ est supérieur au temps de relaxation longitudinal $T_1$, les composantes longitudinales de l'aimantation reviennent à la position d'équilibre d'origine avant chaque répétition. Dans ce cas là, l'aimantation ne subit pas l'effet de la relaxation longitudinale d'une répétition à l'autre. Le contraste des images obtenues est alors indépendant du temps de relaxation longitudinale $T_1$.

Lorsque le temps de répétition $T_r$ devient inférieur au temps de relaxation longitudinale $T_1$, les

composantes longitudinales de l'aimantation n'arrive plus à reprendre leurs valeurs d'équilibre d'origine quand la répétition suivante commence. L'excitation suivante bascule alors l'aimantation longitudinale qui a une valeur inférieure à l'aimantation d'équilibre. Le signal mesuré pendant cette répétition intègre donc l'influence du temps de relaxation longitudinale $T_1$. Dans ce cas là, le temps de relaxation $T_1$ participe au contraste des images.

Les temps de relaxation longitudinale $T_1$ et transversale $T_2$ pour les tissus biologiques, notamment d'un corps humain ou animal, sont très variables en fonction de paramètres biologiques du corps et de paramètres physiques des champs, tels que l'intensité du champ statique $B_0$. Les ordres de grandeur sont, d'une manière générale, de 0,3 à 2 secondes pour $T_1$ et de 20 à 200 millisecondes pour $T_2$. Dans le cas des liquides biologiques, $T_2$ se rapproche de $T_1$ et est de l'ordre de 2 secondes. Les temps de relaxation $T_1$ et $T_2$ sont d'excellents indicateurs biochimiques et pathologiques.

Pour les examens cliniques, on préfère avoir des images dont le contraste dépend uniquement du temps de relaxation longitudinale $T_1$ ou du temps de relaxation transversale $T_2$. Pour simplifier, les images contrastées en $T_1$ donnent plutôt des informations anatomiques du corps examiné, tandis que les images contrastées en $T_2$ fournissent plutôt des informations pathologiques du corps.

Pour l'obtention des images contrastées en $T_1$, il suffit de choisir un temps de répétition $T_r$ inférieur au temps de relaxation longitudinale $T_1$, et un temps d'écho $T_e$ très inférieur, par exemple d'un facteur 5, au temps de relaxation transversal $T_2$. Lorsque le temps d'écho $T_e$ est très petit devant $T_2$, la variation de l'aimantation transversale n'est pas significative pour l'écho. Le signal mesuré représente donc uniquement l'influence du temps de relaxation longitudinale $T_1$.

D'une manière générale, les médecins préfèrent utiliser des images contrastées en temps de relaxation transversale $T_2$, du fait que $T_2$ est très sensible à la qualité des tissus mous observés. Le temps de relaxation transversale $T_2$ pour un tissu malade est supérieur à celui d'un tissu normal.

Pour obtenir une image contrastée en $T_2$, il suffit de choisir un temps de répétition $T_r$ supérieur au temps de relaxation longitudinal $T_1$, pour que l'aimantation longitudinale puisse se rétablir complètement avant l'excitation suivante. On peut également obtenir une image contrastée uniquement en intensité de l'aimantation d'équilibre $M_0$ qui indique la densité de protons, en choisissant par exemple un temps d'écho $T_e$ inférieur à un cinquième du temps de relaxation transversale $T_2$.

Comme déjà mentionné précédemment, selon l'invention, la première impulsion d'excitation 1 bascule l'aimantation d'un angle $\alpha$ supérieur ou égal à 90° et inférieur à 180°. Les composantes longitudinales de l'aimantation à la fin de cette première impulsion d'excitation sont dirigées dans le sens opposé à l'aimantation d'équilibre initial. La seconde impulsion d'excitation 8 bascule de nouveau l'aimantation d'un angle de 180°, ce qui a pour effet de restituer les composantes longitudinales dans le même sens que l'aimantation d'équilibre intial et réduire le temps pour la relaxation longitudinale de l'aimantation. Il en résulte que le procédé de la présente invention permet de réduire le temps de répétition $T_r$ grâce à la combinaison des deux impulsions d'excitation 1 et 8. Le temps d'acquisition d'une image tridimentionnelle contrastée en $T_2$ et $M_0$ peut être considérablement réduit. Le temps de pose pour l'examen clinique se trouve alors considérablement réduit.

Une image tridimensionnelle d'un corps permet une visualisation du corps selon des plans de coupe arbitraires sans avoir de discontinuité entre deux coupes successives.

On donnera maintenant un exemple spécifique d'examen par imagerie médicale selon l'invention de la tête d'un patient :

La tête du patient est placée dans un champ magnétique statique $B_0$ dont l'intensité est égale à 0,1 Tesla. On applique un champ d'excitation $B_1$ perpendiculaire au champ $B_0$ et dont la vitesse angulaire autour de $B_0$ correspond à 4,26 MHz. L'angle de basculement $\alpha$ est égal à 140°. Le temps de répétition $T_r$ est égal à 100 ms. Le temps d'écho $T_e$ est égal à 20 ms. Une image bidimensionnelle constituée de 128 x 256 pixels ou de 256 x 256 pixels correspondant à un plan de coupe choisi peut être obtenue au bout d'une vingtaine de secondes. Une image tridimensionnelle constituée de 32 x 256 x 256 pixels peut être obtenue en une dizaine de minutes. Cette image tridimensionnelle permet notamment de visualiser, selon un plan de coupe quelconque, l'encéphale et la charnière bulbo-médullaire du patient.

## Revendications

1. Procédé d'imagerie par résonance magnétique nucléaire d'un corps disposé dans un champ magnétique statique ($B_0$), caractérisé par les étapes suivantes se succédant séquentiellement :
- appliquer perpendiculairement au champ statique ($B_0$), un champ magnétique d'excitation ($B_1$) sous forme d'une première impulsion (1) tournant autour du champ statique avec une vitesse angulaire qui correspond sensiblement à la fréquence de résonance d'un type de noyaux atomiques constituant le corps sous le champ statique ($B_0$), l'amplitude

(B₁) et la durée (t) de première impulsion d'excitation (1) étant telles que l'aimantation (M) du corps induite dans le champ statique (B₀) est basculée d'un angle (α) compris entre 90° et 180° par rapport à sa position d'équilibre d'origine dans le champ statique;

- appliquer selon l'un des trois axes d'un repère tridimensionnel un gradient de champ magnétique de lecture (Gₓ) sous forme d'une première impulsion (2), et simultanément appliquer au moins un gradient de champ magnétique de codage de phase (Gᵧ, G_z) sous forme d'une première impulsion (3, 4) et suivant au moins un des deux autres axes du repère tridimensionnel;

- appliquer une seconde impulsion de gradient de champ magnétique (5, 6, 7) suivant chacun des axes du repère tridimensionnel;

- appliquer une seconde impulsion (8) du champ d'excitation (B₁) dont l'amplitude et la durée sont telles que l'aimantation (M) bascule de nouveau d'un angle de 180°;

- appliquer une troisième impulsion de gradient de champ magnétique (9, 10, 11) suivant chacun des axes du repère tridimensionnel;

- appliquer une quatrième impulsion (12) de gradient de lecture (Gₓ) en maintenant les gradients de codage de phase (Gᵧ, G_z) supprimés;

- mesurer le signal (13) pendant cette quatrième impulsion (12) de gradient de lecture, et traiter le signal mesuré par des techniques connues en soi pour reconstituer une image numérique;

- appliquer une cinquième impulsion (14) de gradient de lecture et simultanément une quatrième impulsion (15, 16) de chacun des deux gradients de codage de phase (Gᵧ, G_z);

- répéter la séquence précédemment définie de telle sorte qu'à chaque répétition, on change l'aire formée par la multiplication de la durée et de l'amplitude de la première impulsion (3, 4) de l'un des gradients de codage de phase (Gᵧ, G_z), les amplitudes des autres impulsions (6, 7; 10, 11; 15, 16) de gradients de codage de phase (Gᵧ, G_z) et les amplitudes des seconde, troisième et cinquième impulsions (5; 9; 14), de gradient de lecture (Gₓ) variant de façon indépendante et aléatoire d'une répétition à l'autre.

2. Procédé d'imagerie selon la revendication 1, caractérisé par le fait que le temps séparant la mi-durée de la première impulsion d'excitation (1) et la mi-durée de la seconde impulsion d'excitation (8) est sensiblement identique au temps séparant la mi-durée de la seconde impulsion d'excitation (8) et l'instant où l'amplitude du signal mesuré (13) est maximale.

3. Procédé d'imagerie selon la revendication 1 ou 2, caractérisé par le fait que l'aire, formée par la multiplication de la durée et de l'amplitude, de la première impulsion (2) du gradient de lecture est identique à l'aire d'une partie de la quatrième impulsion (12) du gradient de lecture comprise entre le début de l'impulsion et l'instant où l'amplitude du signal mesuré est maximale.

4. Procédé d'imagerie selon l'une quelconque des revendications précédentes, caractérisé par le fait qu'à chaque répétition et pour chaque gradient de champ magnétique (Gₓ, Gᵧ, G_z), les aires correspondant aux seconde et troisième impulsions (5, 9; 6, 10; 7, 11) sont identiques.

5. Procédé d'imagerie selon la revendication 4, caractérisé par le fait que les seconde et troisième impulsions de gradients sont identiques en amplitude et en durée.

6. Proocédé d'imagerie selon l'une quelconque des revendications précédentes, caractérisé par le fait qu'au moins un des groupes (5, 6, 7; 9, 10, 11; 14, 15, 16) d'impulsions d'amplitude aléatoire des gradients de champ magnétique (Gₓ, Gᵧ, G_z) vérifie la relation suivante :

$$\gamma (G_x t_x Dx + G_y t_y Dy + G_z t_z Dz)) \gtrless 2\pi$$

où γ est le rapport gyromagnétique caractéristique du type de noyaux atomiques considéré; Gₓ, Gᵧ, G_z sont les amplitudes respectives des gradients de champ magnétique; tₓ, tᵧ, t_z sont les durées d'impulsions respectives des gradients de champ magnétique; Dx, Dy, Dz sont les côtés respectifs d'un volume élémentaire du corps correspondant à un point d'image numérique.

7. Procédé d'imagerie selon l'une quelconque des revendications précédente, caractérisé par le fait que l'angle de basculement (α) de l'aimantation (M) par la première impulsion (1) du champ d'excitation (B₁) est constant et inchangé d'une répétition à l'autre de la séquence.

8. Procédé d'imagerie selon l'une quelconque des revendications précédentes, caractérisé par le fait qu'en outre, pour chaque répétition de la séquence et avant les premières impulsions (2, 3, 4) des gradients de champ magnétique, on applique un gradient de sélection suivant au moins un des axes du repère tridimensionnel sous forme d'une première partie d'impulsion pendant laquelle est appliquée la première impulsion d'excitation (1) suivie d'une seconde partie d'impulsion dont l'amplitude est de signe contraire à celui de la première partie d'impulsion, l'aire de la première partie d'impulsion après la mi-durée de la première impulsion d'excitation (1) étant sensiblement égale à l'aire de la seconde partie d'impulsion du gradient de sélection.

# FIG.1a

# FIG.1b

# FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 223 543 (PICKER INTERNATIONAL LTD) <br> * Colonne 1, lignes 3-46; colonne 3, lignes 16-56; figure 2 * <br> --- | 1 | G 01 R 33/56 |
| A | US-A-4 803 432 (W.H. PERMAN) <br> * Colonne 7, ligne 60 - colonne 8, ligne 65; figure 4 * <br> --- | 1 | |
| A | EP-A-0 191 431 (MAX-PLANCK-GESELLSCHAFT ZUR FÖRDERUNG DER WISSENSCHAFTEN e.V.) <br> * Abrégé; colonne 11, ligne 36 - colonne 13, ligne 55; figures 7,10 * <br> --- | 1 | |
| A | JOURNAL OF MAGNETIC RESONANCE, vol. 65, 1985, pages 298-307, New York, US; W. SATTIN et al.: "Exploiting the stimulated echo in nuclear magnetic resonance imaging. II. Applications" <br> * En entier * <br> ----- | 1 | |

**DOMAINES TECHNIQUES RECHERCHES (Int. Cl.5)**

G 01 N
G 01 R

Le présent rapport a été établi pour toutes les revendications

| Lieu de la recherche | Date d'achèvement de la recherche | Examinateur |
|---|---|---|
| LA HAYE | 02-10-1990 | HORAK G.I. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)